# EUROPEAN PATENT SPECIFICATION

(11) **EP 4 111 484 B1**
(45) Date of publication and mention of the grant of the patent: **29.01.2025**
(21) Application number: 21712043.5
(22) Date of filing: 25.02.2021
(51) Int. Cl.: H01J 37/141

(54) **POLE PIECE FOR A TRANSMISSION ELECTRON MICROSCOPE**
POLSTÜCK FÜR EIN ELEKTRONENMIKROSKOP
PIÈCE POLAIRE POUR UN MICROSCOPE ÉLECTRONIQUE

(30) Priority: 25.02.2020 EP 20159344
(43) Date of publication of application: 04.01.2023
(73) Proprietor: The Provost, Fellows, Scholars and other Members of Board of Trinity College Dublin, Dublin 2 (IE)
(72) Inventor: JONES, Lewys, Dublin 2 (IE); O'MAHONY, David, Dublin 2 (IE)
(74) Representative: Purdylucey Intellectual Property
(86) International application number: PCT/EP2021/054761
(87) International publication number: WO 2021/170762

(56) References cited:
- JP-A- S59 221 953
- JP-A- S61 131 350
- JP-U- S5 841 571

## Description

### Field

The disclosure relates to a pole piece for an electron microscope, and in particular a Transmission Electron Microscope (TEM). The disclosure also relates to a pole piece for use in charged particle devices, such as electron-beam lithography instruments (EBL), e-beam sterilisation instruments, or e-beam 3D-printers and the like.

### Background

An electron microscope is a microscope that uses a beam of accelerated electrons as a source of illumination. As the wavelength of an electron can be up to 100,000 times shorter than that of visible light photons, electron microscopes have a higher resolving power than light microscopes and can reveal the structure of smaller objects.

Electron microscopes are used to investigate the ultrastructure of a wide range of biological and inorganic specimens including microorganisms, cells, large molecules, biopsy samples, metals, and crystals. Industrially, electron microscopes are often used for quality control and failure analysis.

There are a number of different types of electron-beam imaging or lithography instruments. One example is a transmission electron microscope (TEM).

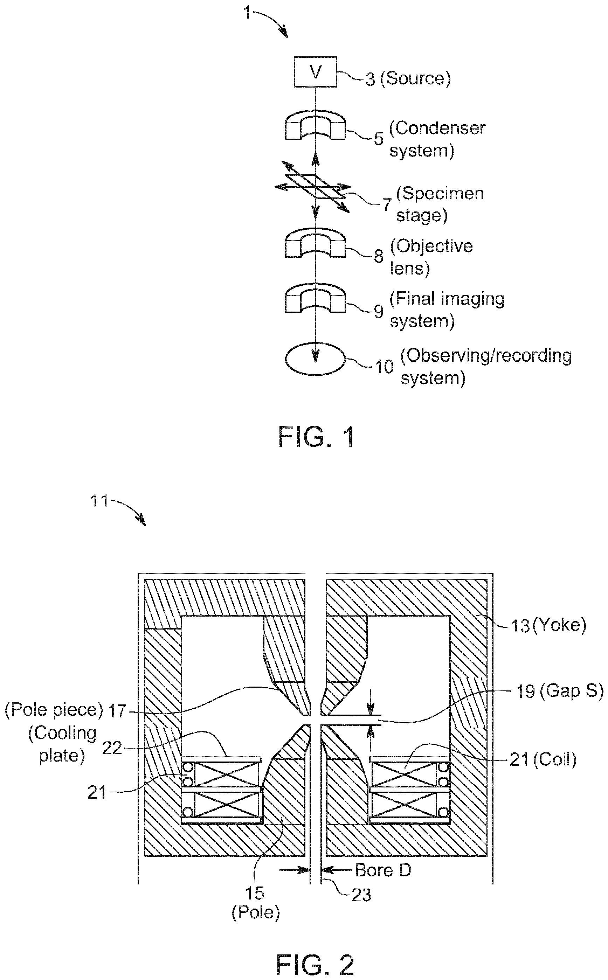

Figure 1 is a schematic diagram of a TEM 1 which shows its basic features. It comprises an electron source 3, a condenser system 5 which focuses the electron beam from the source, a specimen stage 7 where the specimen is held, an objective lens 9 which collects and focuses electrons which have been transmitted through the sample and an imaging lens which expands the beam onto an imaging device 10. The elements are all typically enclosed in a vacuum chamber. A TEM uses a high voltage to create an electron beam which is produced by an electron gun. The electron beam is accelerated by an electric field to a desired energy.

The electromagnetic lens is usually made of a solenoid coil nearly surrounded by ferromagnetic materials designed to concentrate the coil's magnetic field into a precise, confined shape. When an electron enters and leaves this magnetic field, it converges around the curved magnetic field lines in a manner similar to an optical converging lens. A magnetic lens's focusing power can be changed by adjusting the current passing through the coils. This allows a lens system, between the source and the sample (the "condenser lens" system) to produce a parallel beam over 1 millimetre in diameter, a tightly focused beam smaller than an atom, or anything in between.

The magnetic field produced for the lens should be radially symmetrical, as deviation from the radial symmetry of the magnetic lens will causes aberrations, such as chromatic or spherical aberration. Electron lenses are generally manufactured from iron, iron-cobalt or nickel cobalt alloys, such as permalloy. These are selected for their magnetic properties, such as magnetic saturation, hysteresis and permeability.

An example cross-section of part of a TEM 11 is shown in Figure 2. This part receives an incident electron beam from a condenser lens. The electromagnet comprises a yoke 13 and coils 21. The sample space comprises a pole gap 19 which is bounded by pole piece 17 mounted on the pole 15. The axially extending space 23 defines a bore which accommodates the beam-path. Control of the strength of the magnetic fields is achieved by varying the current in the coils and shapes the electron beam.

The pole piece is a magnetic pole made of a soft magnetic material (for example pure iron, Permandur, Hiperco50 or similar material) which concentrates the magnetic flux produced by the electromagnet and is guided by the yoke to produce a strong magnetic field in a narrow gap in the polepiece. Pole pieces are known for a long time in electron lens systems, for example various pole piece designs are disclosed in US3,324,433; US2,749,464; US2,472,315; US2,754,443 and US2,418,432, however none of these pole pieces are suitable for incorporation in modern electron microscopes.

Other patent publications including GB2161019; US20110012018 and JP2000156191 disclose pole pieces exclusively for scanning electron microscopes (SEM) and the type of lens that is used is a 'pinhole' or 'snorkel' lens. Such pole pieces can be interchangeable and are found not to be very practical. For example, GB2161019 shows interchangeable modules that need the column to be vented to atmosphere to make the replacement. This is undesirable and not possible for TEM microscopes without dismantling and reassembling.

The pole gap largely dictates the final shape of the magnetic field incident upon the sample. The geometry of an installed pole piece may be optimised for different purposes and is selected when an instrument is purchased. This configuration will then typically remain for the entire lifetime of the microscope (perhaps 20 years).

JP-S-61131350 shows a polepiece with variable distance between upper and lower distance.

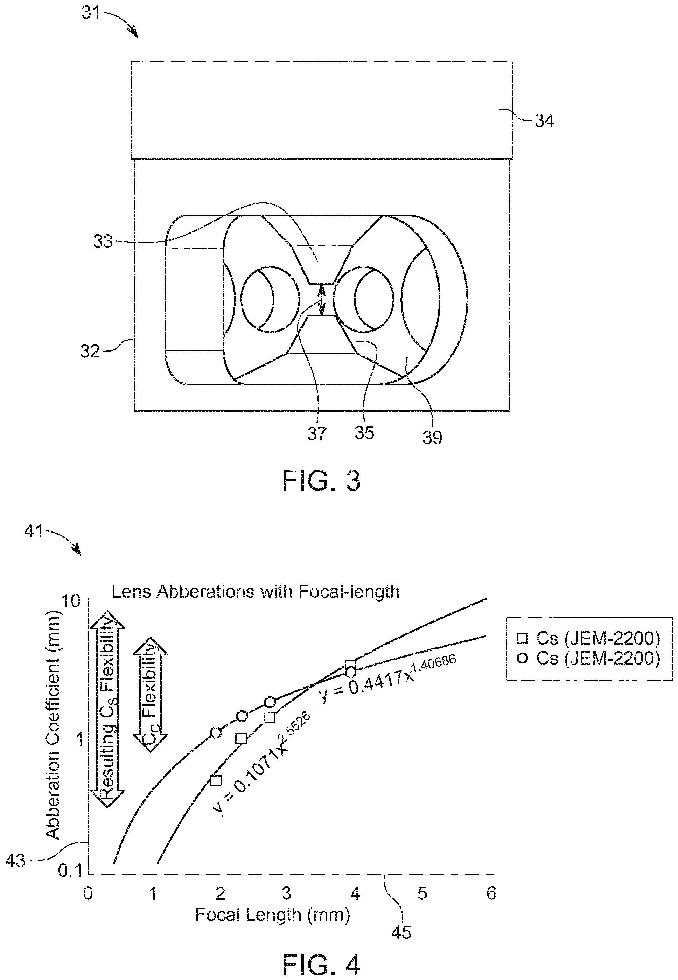

Figure 3 shows an example of a pole-piece 31, known in the art for use in a TEM microscope, which comprises an upper pole 33 positioned towards the electron source and condenser lens of the microscope and a lower pole 35. The upper pole 33 and lower pole 35 are hollow and frustoconical in shape with the poles pointing towards one another. The smaller, lower pole 35 engages with the remainder of the iron magnetic circuit via its base portion, while the upper (larger) pole 33 mates with a base portion 34. The opposing adjacent planes of the upper and lower pole are separated by a fixed gap 37. The upper and lower poles 33, 35 are held at a fixed separation by a supporting frame 32 made from some non-magnetic material. This frame may include ports 39 for various access requirements.

Figure 4 is a known graph 41 which plots the spherical and chromatic aberration coefficients 43 (the two dominant optical defects in these systems) against the focal length 45 of various available pole-pieces. Because of unavoidable physical limitations to the shaping of magnetic fields, the optical quality of electron lenses scales with their focal length which itself scales with the pole-piece gap size.

For example, a microscopist purchasing a new state-of-the-art TEM (at a cost of around €4-5M) may select a small-gap ultra-high-resolution pole-piece (UHR), an intermediate resolution (HR) pole-piece, or a so-called 'analytical' (ARP) with a larger gap. Selection of the configuration of a pole piece may be made to, for example, provide maximum image resolution (a smaller gap size and focal length) or to maximum chemical mapping sensitivity (using a larger gap size to allow closer approach of spectrometers or mirrors), but these features of the output cannot both be maximised for a single pole piece configuration. As a result, an Ultra-high-resolution (UHR) pole-piece is required for the microscope to deliver on its ultimate resolution potential but this severely limits the potential for x-ray spectroscopic collection. The analytical-resolution pole-piece (ARP) on the other hand allows for better chemical spectroscopy and greater tilting or a wider range of in-situ experiments, but at the cost of some lost resolution.

In principle it would be possible for a customer to request the manufacturer to exchange the pole-piece on a modern-generation TEM, but this can incur a down-time of around one month per change and great associated expense.

It is an object of the present invention to create a pole piece for a transmission electron microscope which addresses the above problems.

### Summary of the Invention

In accordance with a first aspect of the invention there is provided, as set out in the appended claims, a pole piece for an electron microscope.

In one embodiment the pole piece comprises:
an upper pole piece, containing a first pathway for an electron beam,
a lower pole piece which is coupled to the upper pole piece and which contains a second pathway operatively connected to the first pathway, the upper pole piece and lower pole piece being separated by a gap between the first pathway and the second pathway,
wherein the pole piece comprises a mechanism which can extend or reduce the distance between the upper pole piece and the lower pole piece by changing the distance between the first pathway and the second pathway.

An important advantage of the pole piece of the present invention is that the spacing between the upper and lower pole piece can be adjusted whilst under vacuum using the mechanism. This provides a major advancement for TEM and STEM microscopes as the invention provides for easy adjustment of pole pieces that heretofore was not possible. Additionally, different samples can be introduced for inspection using the microscope with minimum effort.

In at least one embodiment, the mechanism adjusts the position of the upper pole piece.

In at least one embodiment, the mechanism moves the upper pole piece towards or away from the lower pole piece whilst maintaining a common axis.

In at least one embodiment, the upper pole piece comprises an outer part with a concentrically mounted inner part.

In at least one embodiment, the inner part is coupled to the mechanism and is moveable to extend or reduce the distance between the upper pole piece and the lower pole piece.

In at least one embodiment, the mechanism comprises a bearing mounted between a sleeve, the sleeve formed from an inner concentric surface of the outer part and an outer concentric surface of the concentrically mounted inner part.

In at least one embodiment, the bearing is actuated by a rotatable cam with the bearing acting as the follower which experiences linear motion.

In at least one embodiment, the bearing and sleeve have cooperating threads which allow the bearing to be rotated and moved in linearly.

In at least one embodiment, the mechanism comprises:
a spacer which couples the outer part of the upper pole piece to the lower pole piece;
an anulus rotatably mounted in a substantially circular channel between the outer part and the inner part of the upper pole piece and connected to an actuator wherein rotation of the annulus causes the actuator to move the inner part to extend or reduce the distance between the upper pole piece and the lower pole piece.

In at least one embodiment, the actuator comprises an inclined ratchet and pawl mechanism.

In at least one embodiment, the mechanism is rotatable in one direction, clockwise or anticlockwise. As the mechanism only rotates in one direction means that pole piece 'locks' into position without any external clamping or braking required.

In at least one embodiment, the inclined ratchet comprises a stepped surface of the outer part of the upper pole piece and the pawl comprises an engaging lower surface of the annulus.

In at least one embodiment, the stepped surface comprises a bottom surface of the channel and the pawl comprises a lower surface of the annulus.

In at least one embodiment, the height of the steps on the stepped surface define discrete values of the size of the distance between the upper pole piece and the lower pole piece and therefore, the gap between the first channel and the second channel.

In at least one embodiment, the annulus includes three pawls. An advantage of having three pawls is that it produces a stable and repeatable positioning to adjust the distance between the upper and lower pole piece.

In at least one embodiment, the step heights define a gap between the upper pole piece end and lower pole piece end of 1.5mm, 4.0mm and 6.5mm respectively.

In at least one embodiment, there are five steps which define a gap between the upper pole piece end and lower pole piece end in increments of 1.25mm from a smallest gap of 1.5mm to a largest gap of 6.5mm. Suitably five steps can be provided spaced at 1.5mm, 2.75mm, 4.0mm, 5.25mm, and 6.5mm.

In at least one embodiment of the present invention, the inner part of the upper pole piece comprises a hollow centred generally cylindrical body having a flange for engagement with the anulus at one end with a frustoconical second end which narrows to meet the pole end of the lower pole piece.

According to the invention, a drive mechanism is used to rotate the annulus.

According to the invention, the drive mechanism comprises a set of gear teeth mounted on its outer circumference of the annulus which are operatively connected to one or more cog which couples the annulus to a drive shaft.

In at least one embodiment, the drive shaft is manually operable.

In at least one embodiment, the drive shaft is machine operable.

In at least one embodiment, a feedback mechanism is provided to note the position of, or number of revolutions of, the drive shaft such that the separation of the upper and lower pole pieces is known. Suitably the distance between the upper and pole piece can be visually displayed. The visual display can be a numerical value, text or colour/symbolic indicator.

In at least one embodiment, a switch/trigger/sensor monitors the position of the upper and/or lower pole piece.

In at least one embodiment, access is provided for a camera or similar device to observe the position of the upper and/or lower pole piece.

In one embodiment there is provided a pole piece for a transmission electron microscope, the pole piece comprising:
an upper pole piece, containing a first pathway for an electron beam,
a lower pole piece which is coupled to the upper pole piece and which contains a second pathway operatively connected to the first pathway, the upper pole piece and lower pole piece being separated by a gap between the first pathway and the second pathway, characterised in that:
   the pole piece comprises a mechanism which can extend or reduce the distance between the upper pole piece and the lower pole piece by changing the distance between the first pathway and the second pathway, wherein, the mechanism comprises a spacer which couples the outer part of the upper pole piece to the lower pole piece; an anulus rotatably mounted in a substantially circular channel between the outer part and the inner part of the upper pole piece and connected to an actuator wherein rotation of the annulus causes the actuator to move the inner part to extend or reduce the distance between the upper pole piece and the lower pole piece.

In one embodiment there is provided a transmission electron microscope comprising a pole piece as claimed in any of appended claims 1 to 20.

### Brief Description of the Drawings

The invention will be more clearly understood from the following description of an embodiment thereof, given by way of example only, with reference to the accompanying drawings, in which:
Figure 1 is a schematic diagram of a TEM as generally known;
Figure 2 is a schematic cross-section of a symmetrical objective-lens of a TEM including a known pole piece;
Figure 3 is a perspective view of a known fixed gap pole piece;
Figure 4 is a graph which plots the aberration coefficient 43 against the focal length of the spherical and chromatic aberrations;
Figures 5a and 5b are schematic representations of a first embodiment of the present invention;
Figure 6 is a cut away perspective view of a second embodiment of the present invention;
Figure 7 is a perspective view of the second embodiment of the present invention;
Figure 8 is a perspective view of the second embodiment of the present invention;
Figures 9a to 9c are side views of the second embodiment of the present invention which show differing gap heights;
Figure 10 is a graph which plots optical axis distance against magnetic flux density for a 1.5mm pole piece gap;
Figure 11 is a graph which plots optical axis distance against magnetic flux density for a 4mm pole piece gap; and
Figure 12 is a graph which plots optical axis distance against magnetic flux density for a 6.5mm pole piece gap.

### Detailed Description of the Drawings

The present invention provides a pole piece for a transmission electron microscope (TEM) which allows the pole piece gap, that is, the gap between the upper pole piece and the lower pole piece to be adjusted without the cost in time and money of disassembling the TEM to replace the pole piece with one having a different sized pole piece gap. Moreover the pole piece of the present invention can work in a vacuum when incorporated into a transmission electron microscope. In other words the upper pole piece and the lower pole piece can be adjusted in a vacuum.

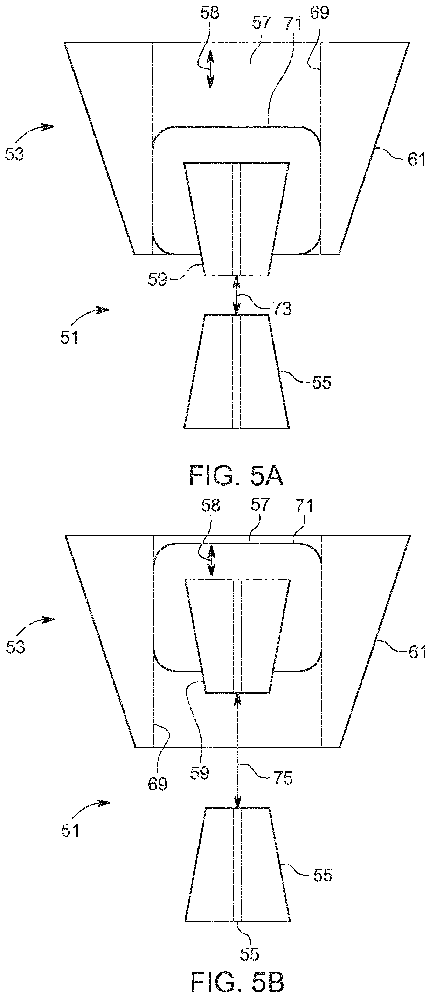

Figures 5a and 5b are schematic diagrams which show a pole piece 51 which has an upper pole piece (UPP) 53 and a lower pole piece (LPP) 55. Pathway inside the UPP 53 illustrates the cavity running the length of the UPP at its centre where the magnetic field is concentrated. The pathway and magnetic field focusses the electrons as they travel from the TEM's electron source to its specimen stage (not shown). A similar pathway is shown in the LPP for electrons once transmitted from the specimen towards the objective and imaging lenses.

In this example of the present invention a mechanism for linear movement of the UPP 53 comprises a carriage or bearing 71 which is positioned between an outer part 61 of the UPP 53 and an inner part 59. The inner part 59 and the outer part 61 are concentric, the centre of the pathway being aligned with the centre of the UPP 53. The bearing is mounted in a sleeve 69 which forms an inner concentric surface of the outer part 61. A spacer (not shown) fixedly can connect the outer part 61 of the UPP 53 to the LPP 55 in practice. The inner part 59 is not so connected and may move linearly as shown by arrow 58 to and from the pole end of the LPP 55.

The carriage or bearing 71 may be actuated in a number of ways, for example a small cam may be mounted on the bearing which may be resiliently mounted such that rotation of the cam will cause linear movement of the bearing which will move the inner part 59 of the UPP 53 linearly as shown by arrow 58. Alternatively, the bearing 71 and sleeve 69 may have cooperating threads which allow the bearing to be rotated and moved in direction 58.

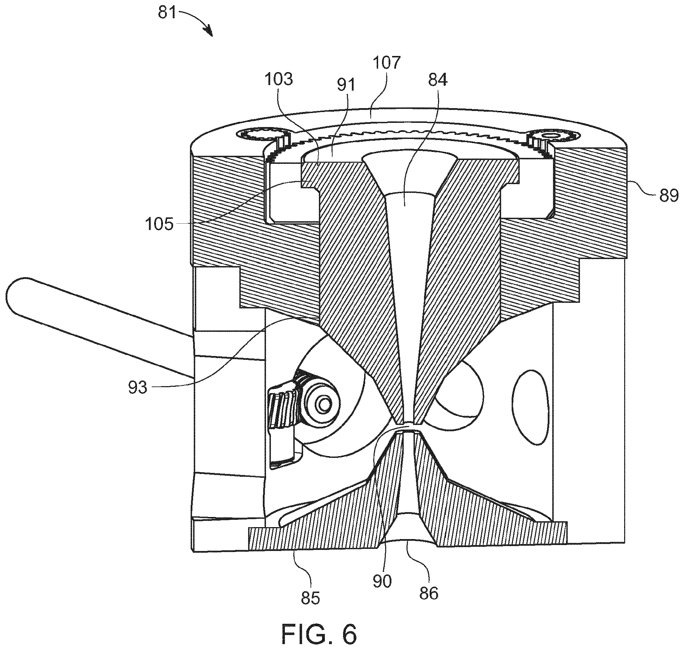

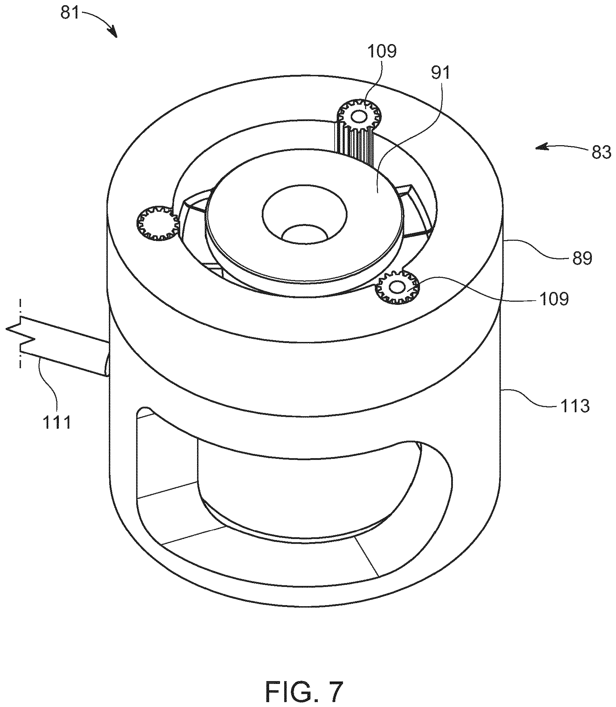

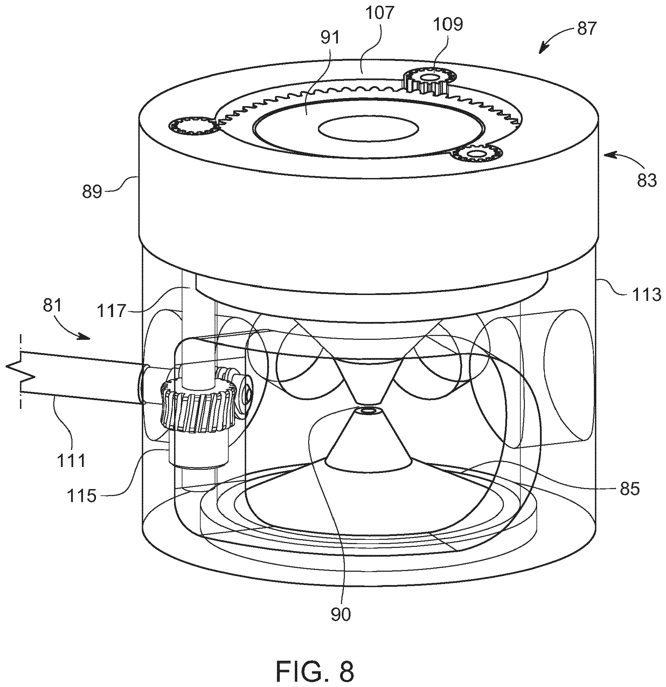

Figures 6 to 9 show a second and another embodiment of the present invention. In figures 6 to 9 reference the same numerals are used to describe the same features when illustrated in different drawings.

Figures 6 to 9 show a pole piece 81 which has an upper pole piece (UPP) 93 and a lower pole piece (LPP) 85. Pathway 84 inside the UPP illustrates the cavity running the length of the UPP at its centre where the magnetic field is concentrated. A similar pathway 86 is shown in the LPP for electrons once transmitted from the specimen towards the objective and imaging lenses. Pathways 84 and 86 are accurately aligned to allow the electrons to pass through to an objective lens (not shown).

In this example, the UPP comprises an outer part 89 and an inner part 91. The outer pole part 89 is supported by a spacer 113 which connects it to the LPP 85. The inner part 91 comprises a hollow centred generally cylindrical body having a flange 105 for engagement with a coupling ring or anulus at one end with a frustoconical second end which narrows to meet the pole end of the lower pole piece 85 at the gap 90. The cylindrical surface of the inner part 91 is slidable connected to the outer part 89 at surface 93.

The coupling ring couples the inner part 91 to a drive mechanism. The outer circumference of the ring has gear teeth 107 which are operatively connected to toothed cogs 109 which, in turn are connected to a gear shaft 117, worm gear 115 and drive shaft 111. It will be appreciated that only one of the three cogs 109 can be is connected to the drive shaft. The other two cogs are free rotating and are used to stabilise the toothed ring. Any combination of cogs can be used

The coupling ring has a tiered bottom surface and is located in a channel 88 which comprises a tiered upwardly pointing surface 98 of the outer UPP 89. The top tier of the upwardly pointing surface comprises an inclined stepped surface, that is, the size of the step increases around the circumference of the channel. The cooperative engagement between the tiered bottom surface of the ring and the steps acts to change the distance between the inner UPP 91 and the LPP 85 upon rotation of the ring. The stepped shape also acts to prevent contra-rotation of the ring, in other words, the inner UPP 91 is engaged on an inclined ratcheting plane so as to lift when rotated. This lifting is then released and the inner portion locks into a new raised position.

The design achieves the required rotation and lifting of the inner UPP using the gear shaft 117 to translate mechanical motion via the worm gear 115 from the external drive shaft 111. A feedback mechanism (not shown) can be provided to cooperate with the drive shaft 111 or gear shaft 117 to note the position of, or number of revolutions of, the drive shaft such that the separation of the upper and lower pole pieces is known. Suitably the distance between the upper and pole piece can be visually displayed. The visual display can be a numerical value or colour indicator. For example, a numerical counter can be used to display the position of the upper and lower pole pieces with respect to each other. A switch/trigger can be provided to monitor the position of the upper and/or lower pole piece. It will be appreciated that the pole piece can be dimensioned to allow access by a camera or other viewing device to visually inspect the pole piece or visually display the physical position of the pole piece within a microscope.

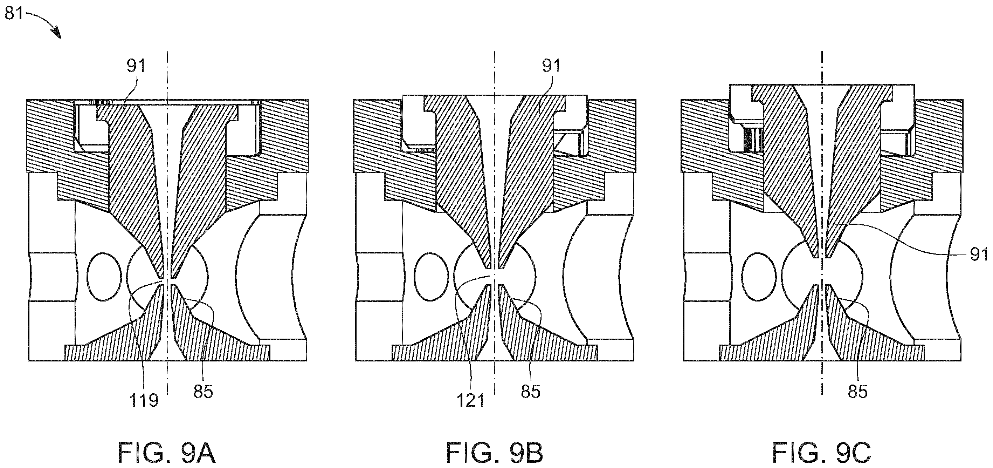

Figures 9a to 9c show an enlargement of the central portion of the adjustable pole-piece 81 as shown in the embodiment of figures 6 to 8 with similar reference numerals.

Figure 9a shows the pole piece 81, with an inner UPP 91, ratchet surface in the channel of the outer UPP 89. Pathways 84 and 86 are accurately aligned to allow the electrons to pass through to the objective lens. In this example, the mechanism moves the inner UPP to set a gap 119 of 1.5mm to the LPP 85.

Figure 9b shows the pole piece 81, with an inner UPP 91, ratchet surface in the channel of the outer UPP 89. Pathways 84 and 86 are accurately aligned to allow the electrons to pass through to the objective lens. In this example, the mechanism moves the inner UPP to set a gap 121 of 4.0mm to the LPP 85.

Figure 9c shows the pole piece 81, with an inner UPP 91, ratchet surface in the channel of the outer UPP 89. Pathways 84 and 86 are accurately aligned to allow the electrons to pass through to the objective lens. In this example, the mechanism moves the inner UPP to set a gap 123 of 6.5mm to the LPP 85.

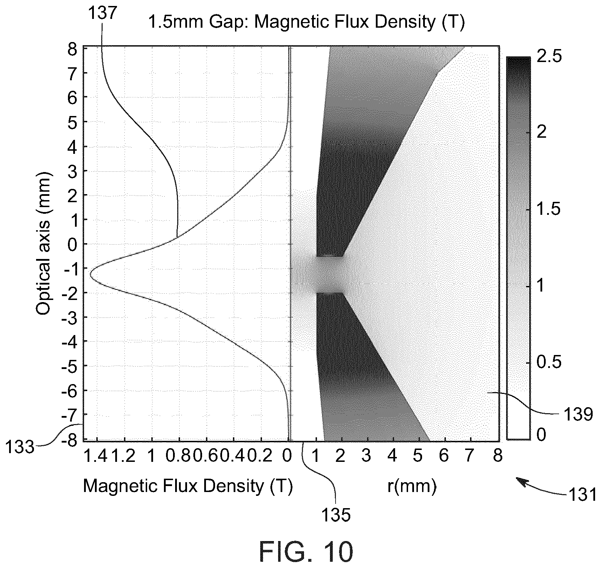

Figure 10 is a graph 131 of optical axis distance 133 against magnetic flux density 135 for a 1.5mm pole piece gap. The curve 137 is a gaussian curve with a single peak. The intensity distribution as a function of the distance from the optical axis 139 is also shown.

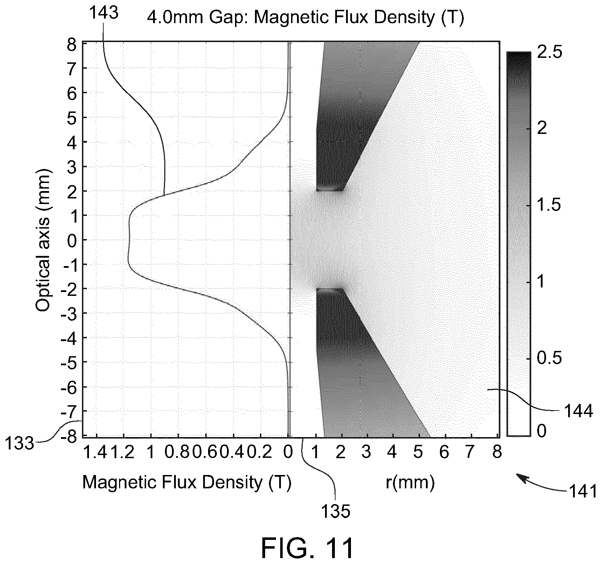

Figure 11 is a graph 141 which plots optical axis distance against magnetic flux density for a 4mm pole piece gap. The curve 143 is a gaussian curve with a narrow double peak. The intensity distribution as a function of the distance from the optical axis 149 is also shown.

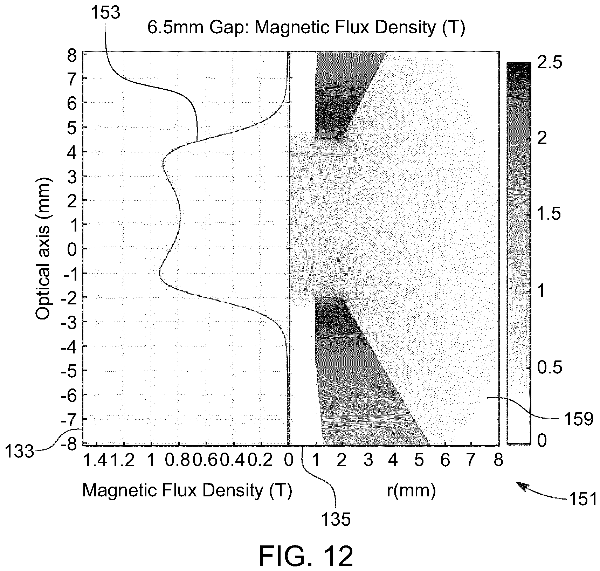

Figure 12 is a graph 151 which plots optical axis distance against magnetic flux density for a 6.5mm pole piece gap. The curve 153 is a gaussian curve with a wide double peak. The intensity distribution as a function of the distance from the optical axis 159 is also shown.

In the context of the present invention the terms 'first pathway' and 'second pathway' is used to describe a bore or channel through and between the pole pieces that allows correct operation of an electron microscope and understood by a person skilled in the art of electron microscopes.

In general, a single peak with a sharp Gaussian distribution of magnetic flux density with respect to optical axis distance would be considered to be an ideal lens, whereas at the more expanded setting the optical quality is poorer but allows a spectrometer to be closer to the sample or larger sample tilts.

In the specification the terms "comprise, comprises, comprised and comprising" or any variation thereof and the terms include, includes, included and including" or any variation thereof are considered to be totally interchangeable and they should all be afforded the widest possible interpretation and vice versa.

The invention is not limited to the embodiments hereinbefore described but may be varied in both construction and detail.

## Claims

1. A pole piece for a transmission electron microscope, the pole piece comprising:
an upper pole piece (93), containing a first pathway (84) for an electron beam,
a lower pole piece (85) which is coupled to the upper pole piece and which contains a second pathway (86) operatively connected to the first pathway, the upper pole piece and lower pole piece being separated by a gap (90) between the first pathway and the second pathway, wherein
the pole piece comprises a mechanism which can extend or reduce the distance between the upper pole piece and the lower pole piece by changing the distance between the first pathway and the second pathway, wherein, the mechanism comprises a spacer (113) which couples the outer part (89) of the upper pole piece to the lower pole piece; an anulus rotatably mounted in a substantially circular channel between the outer part and the inner part (91) of the upper pole piece and connected to an actuator wherein rotation of the annulus causes the actuator to move the inner part to extend or reduce the distance between the upper pole piece and the lower pole piece, wherein a drive mechanism is used to rotate the annulus, **characterized by** the drive mechanism comprising a set of gear teeth mounted on the outer circumference of the annulus which are operatively connected to one or more cog (109) which couples the annulus to a drive shaft (111).

2. The pole piece as claimed in claim 1 wherein, the upper pole piece comprises an outer part with a concentrically mounted inner part.

3. The pole piece as claimed in claim 2 wherein, the inner part is coupled to the mechanism and is moveable to extend or reduce the distance between the upper pole piece and the lower pole piece.

4. The pole piece as claimed in claim 3 wherein, the mechanism comprises a bearing mounted between a sleeve, the sleeve formed from an inner concentric surface of the outer part and an outer concentric surface of the concentrically mounted inner part.

5. The pole piece as claimed in claim 4 wherein, the bearing is actuated by a rotatable cam with the bearing acting as the follower which experiences linear motion.

6. The pole piece as claimed in claim 5 wherein, the bearing and sleeve have cooperating threads which allow the bearing to be rotated and moved linearly.

7. The pole piece as claimed in any preceding claim wherein, the actuator comprises an inclined ratchet and pawl mechanism.

8. The pole piece as claimed in claim 7 wherein, the inclined ratchet comprises a stepped surface of the outer part of the upper pole piece and the pawl comprises an engaging lower surface of the annulus.

9. The pole piece as claimed in claim 8 wherein, stepped surface the stepped surface comprises a plurality of steps, the height of the steps on the stepped surface define discrete values of the size of the distance between the upper pole piece and the lower pole piece and therefore, the gap between the first channel and the second channel.

10. The pole piece as claimed in claim 1 wherein, the drive shaft is manually operable.

11. The pole piece as claimed in claim 1 wherein, the drive shaft is machine operable.

12. The pole piece as claimed in any preceding claim comprising a feedback mechanism to note the position of, or number of revolutions of, the drive shaft such that the separation of the upper and lower pole pieces is known.

13. The pole piece as claimed in any preceding claim wherein a switch/trigger monitors the position of the upper and/or lower pole piece.

14. The pole piece as claimed in any preceding claim wherein access is provided for a camera or similar device to observe the position of the upper and/or lower pole piece.

15. A transmission electron microscope comprising a pole piece as claimed in any of claims 1 to 14.

## Patentansprüche

1. Polstück für ein Transmissionselektronenmikroskop, wobei das Polstück Folgendes umfasst:
ein oberes Polstück (93), das eine erste Bahn (84) für einen Elektronenstrahl enthält,
ein unteres Polstück (85), das mit dem oberen Polstück gekoppelt ist und das eine zweite Bahn (86), die in Wirkbeziehung mit der ersten Bahn verbunden ist, enthält, wobei das obere Polstück und das untere Polstück durch einen Spalt (90) zwischen der ersten Bahn und der zweiten Bahn getrennt sind, wobei das Polstück einen Mechanismus umfasst, der den Abstand zwischen dem oberen Polstück und dem unteren Polstück durch Ändern des Abstands zwischen der ersten Bahn und der zweiten Bahn vergrößern oder verkleinern kann, wobei der Mechanismus ein Distanzstück (113) umfasst, das das Außenteil (89) des oberen Polstücks mit dem unteren Polstück koppelt; wobei ein ringförmiges Teil in einem im Wesentlichen kreisförmigen Kanal zwischen dem Außenteil und dem Innenteil (91) des oberen Polstücks drehbar montiert und mit einem Aktor verbunden ist, wobei eine Drehung des ringförmigen Teils bewirkt, dass der Aktor das Innenteil bewegt, um den Abstand zwischen dem oberen Polstück und dem unteren Polstück zu vergrößern oder zu verkleinern, wobei zum Drehen des ringförmigen Teils ein Antriebsmechanismus verwendet wird, **dadurch gekennzeichnet, dass**
der Antriebsmechanismus einen Satz von auf dem Außenumfang des ringförmigen Teils montierten Getriebezähnen umfasst, die in Wirkbeziehung mit einem oder mehreren Zahnrädern (109) verbunden sind, wodurch das ringförmige Teil mit einer Antriebswelle (111) gekoppelt wird.

2. Polstück nach Anspruch 1, wobei das obere Polstück ein Außenteil mit einem konzentrisch montierten Innenteil umfasst.

3. Polstück nach Anspruch 2, wobei das Innenteil mit dem Mechanismus gekoppelt ist und beweglich ist, um den Abstand zwischen dem oberen Polstück und dem unteren Polstück zu vergrößern oder zu verkleinern.

4. Polstück nach Anspruch 3, wobei der Mechanismus ein Lager umfasst, das innerhalb einer Hülse montiert ist, wobei die Hülse aus einer konzentrischen Innenoberfläche des Außenteils und einer konzentrischen Außenoberfläche des konzentrisch montierten Innenteils gebildet ist.

5. Polstück nach Anspruch 4, wobei das Lager durch einen drehbaren Nocken betätigt wird, wobei das Lager als der Stößel fungiert, der eine lineare Bewegung erfährt.

6. Polstück nach Anspruch 5, wobei das Lager und die Hülse zusammenwirkende Gewinde aufweisen, die zulassen, dass das Lager gedreht und linear bewegt wird.

7. Polstück nach einem der vorhergehenden Ansprüche, wobei der Aktor ein geneigtes Klinkengesperre umfasst.

8. Polstück nach Anspruch 7, wobei das geneigte Sperrklinkenrad eine gestufte Oberfläche des Außenteils des oberen Polstücks umfasst und die Sperrklinke eine eingreifende untere Oberfläche des ringförmigen Teils umfasst.

9. Polstück nach Anspruch 8, wobei die gestufte Oberfläche eine Vielzahl von Stufen umfasst und die Höhe der Stufen auf der gestuften Oberfläche diskrete Werte der Größe des Abstands zwischen dem oberen Polstück und dem unteren Polstück und deshalb die Lücke zwischen dem ersten Kanal und dem zweiten Kanal definiert.

10. Polstück nach Anspruch 1, wobei die Antriebswelle manuell betreibbar ist.

11. Polstück nach Anspruch 1, wobei die Antriebswelle maschinell betreibbar ist.

12. Polstück nach einem der vorhergehenden Ansprüche, das einen Rückkopplungsmechanismus zum Erfassen der Position oder der Drehzahl der Antriebswelle umfasst, sodass die Trennung des oberen und des unteren Polstücks bekannt ist.

13. Polstück nach einem der vorhergehenden Ansprüche, wobei ein Schalter/Auslöser die Position des oberen und/oder des unteren Polstücks überwacht.

14. Polstück nach einem der vorhergehenden Ansprüche, wobei ein Zugang für eine Kamera oder ähnliche Einrichtung zum Beobachten der Position des oberen und/oder des unteren Polstücks vorgesehen ist.

15. Transmissionselektronenmikroskop, das ein Polstück nach einem der Ansprüche 1 bis 14 umfasst.

## Revendications

1. Pièce de pôle pour microscope électronique en transmission, la pièce de pôle comprenant :
une pièce de pôle supérieure (93), contenant un premier chemin (84) destiné à un faisceau d'électrons,
une pièce de pôle inférieure (85) qui est accouplée à la pièce de pôle supérieure et qui contient un second chemin (86) fonctionnellement raccordé au premier chemin, la pièce de pôle supérieure et la pièce de pôle inférieure étant séparées par un espace (90) entre le premier chemin et le second chemin, la pièce de pôle comprenant un mécanisme qui peut étendre ou réduire la distance entre la pièce de pôle supérieure et la pièce de pôle inférieure en changeant la distance entre le premier chemin et le second chemin, le mécanisme comprenant une entretoise (113) qui accouple la partie externe (89) de la pièce de pôle supérieure à la pièce de pôle inférieure ; un anneau monté rotatif dans un canal sensiblement circulaire entre la partie externe et la partie interne (91) de la pièce de pôle supérieure et raccordé à un actionneur, une rotation de l'anneau amenant l'actionneur à déplacer la partie interne pour étendre ou réduire la distance entre la pièce de pôle supérieure et la pièce de pôle inférieure, un mécanisme d'entraînement étant utilisé pour tourner l'anneau, **caractérisée en ce que**
le mécanisme d'entraînement comprend une série de dents d'engrenage montées sur la circonférence externe de l'anneau qui sont fonctionnellement raccordées à une ou plusieurs roues dentées (109) qui couplent l'anneau à une tige d'entraînement (111).

2. Pièce de pôle selon la revendication 1, la pièce de pôle supérieure comprenant une partie externe pourvue d'une partie interne montée de manière concentrique.

3. Pièce de pôle selon la revendication 2, la partie interne étant accouplée au mécanisme et étant mobile pour étendre ou réduire la distance entre la pièce de pôle supérieure et la pièce de pôle inférieure.

4. Pièce de pôle selon la revendication 3, le mécanisme comprenant un support monté entre un manchon, le manchon étant formé d'une surface concentrique interne de la partie externe et une surface concentrique externe de la partie interne montée de manière concentrique.

5. Pièce de pôle selon la revendication 4, le support étant actionné par une came rotative, le support agissant comme le suiveur qui subit un mouvement linéaire.

6. Pièce de pôle selon la revendication 5, le support et le manchon comportant des filets coopérants qui permettent de tourner et déplacer linéairement le support.

7. Pièce de pôle selon l'une quelconque des revendications précédentes, l'actionneur comprenant un mécanisme à rochet incliné et cliquet.

8. Pièce de pôle selon la revendication 7, le rochet incliné comprenant une surface en gradins de la partie externe de la pièce de pôle supérieure et le cliquet comprenant une surface inférieure de mise en prise de l'anneau.

9. Pièce de pôle selon la revendication 8, la surface en gradins comprenant une pluralité de gradins, la hauteur des gradins sur la surface en gradins définissant des valeurs discrètes de la dimension de la distance entre la pièce de pôle supérieure et la pièce de pôle inférieure et par conséquent, l'espace entre le premier canal et le second canal.

10. Pièce de pôle selon la revendication 1, la tige d'entraînement pouvant être actionnée manuellement.

11. Pièce de pôle selon la revendication 1, la tige d'entraînement pouvant être actionnée par une machine.

12. Pièce de pôle selon l'une quelconque des revendications précédentes comprenant un mécanisme de rétroaction permettant de noter la position, ou le nombre de tours, de la tige d'entraînement de telle sorte que la séparation des pièces de pôle supérieure et inférieure soit connue.

13. Pièce de pôle selon l'une quelconque des revendications précédentes, un commutateur/déclencheur surveillant la position de la pièce de pôle supérieure et/ou inférieure.

14. Pièce de pôle selon l'une quelconque des revendications précédentes, un accès étant ménagé pour une caméra ou un dispositif similaire afin d'observer la position de la pièce de pôle supérieure et/ou inférieure.

15. Microscopie électronique en transmission comprenant une pièce de pôle selon l'une quelconque des revendications 1 à 14.
